# EUROPÄISCHE PATENTANMELDUNG

(11) **EP 2 442 627 A1**
(43) Veröffentlichungstag der Anmeldung: **18.04.2012**
(21) Anmeldenummer: 10187779.3
(22) Anmeldetag: 15.10.2010
(51) Int. Cl.: H05K 1/02, H05K 7/20, H05K 5/00, F21S 8/00

(54) **Kraftfahrzeugleuchte**

(71) Anmelder: Odelo GmbH, 71409 Schwaikheim (DE)
(72) Erfinder: Barthel, Frank, 71292, Friolzheim (DE)
(74) Vertreter: Benninger, Johannes

(57) **Zusammenfassung**

Es wird eine Kraftfahrzeugleuchte mit einem durch ein Leuchtengehäuse (01) und eine dieses abschließende Lichtscheibe umschlossenen Leuchteninnenraum (02) beschrieben. Der Leuchteninnenraum beherbergt zumindest einen Leuchtmittelträger (01) mit Leiterbahnen (03). Auf dem zumindest einen Leuchtmittelträger (01) ist zusätzlich zu mindestens einer LED (07) mindestens ein weiteres Elektronikbauelement (05) angeordnet und elektrisch kontaktiert. Die Elektronikbauelemente (06, 02, 05, 07) sind nach wärmeempfindlichen Bauelementen (02), zu denen wenigstens die mindestens eine LED (07) zählt, und nach Leistungsbauelementen (05) unterschieden. Wenigstens eine in einem Leuchtmittelträger (01) angeordnete Wärmebresche (04) ist zumindest zwischen einem Leistungsbauelement (05) und einem wärmeempfindlichen Bauelement (02) angeordnet.

## Beschreibung

Die Erfindung betrifft eine Kraftfahrzeugleuchte gemäß dem Oberbegriff des Anspruchs 1.

Eine Kraftfahrzeugleuchte erfüllt je nach Ausgestaltung eine oder mehrere Aufgaben bzw. Funktionen, wie beispielsweise bei einer Ausgestaltung als Scheinwerfer eine die Fahrbahn ausleuchtende Funktion, oder bei einer Ausgestaltung als Signalleuchte eine Signalfunktion, wie beispielsweise zur Fahrtrichtungsanzeige oder Anzeige einer Bremstätigkeit, oder einer Sicherstellung einer Sichtbarkeit des Kraftfahrzeugs bei Tag und/oder Nacht, wie etwa bei einer Ausgestaltung als Tagfahrleuchte. Beispiele für Kraftfahrzeugleuchten sind am Fahrzeugbug, an den Fahrzeugflanken und/oder an den Seitenspiegeln sowie am Fahrzeugheck angeordnete Blinkleuchten, Ausstiegsleuchten, beispielsweise zur Umfeldbeleuchtung, Begrenzungsleuchten, Bremsleuchten, Nebelleuchten, Rückfahrleuchten, sowie typischerweise hoch gesetzte dritte Bremsleuchten, so genannte Central, High-Mounted Braking Lights, Tagfahrleuchten, Scheinwerfer und auch als Abbiege- oder Kurvenlicht verwendete Nebelscheinwerfer, sowie Kombinationen hiervon.

Eine Kraftfahrzeugleuchte besteht im Wesentlichen aus einem Gehäuse, einem darin angeordneten Leuchtmittel, gegebenenfalls einem typischerweise hinter dem Leuchtmittel in dem Gehäuse angeordneten oder durch dieses beispielsweise vermittels einer zumindest teilweisen Beschichtung gebildeten Reflektor und/oder einem vor dem Leuchtmittel angeordnete Optikelement, wie etwa einer Linse, einem Rinnenkonzentrator, z.B. einer Parabolrinne (CPC; Compound Parabolic Concentrator) oder dergleichen zur Ausformung einer definierten Abstrahlcharakteristik, sowie einer das Leuchtmittel und gegebenenfalls den Reflektor bzw. das Optikelement gegen Witterungseinflüsse schützenden, kurz auch als Lichtscheibe bezeichneten transparenten Abdeckung. Die Lichtscheibe umschließt gemeinsam mit dem Gehäuse einen das Leuchtmittel und gegebenenfalls den Reflektor aufnehmenden Leuchteninnenraum. In dem Leuchteninnenraum kann zwischen Leuchtmittel und Lichtscheibe eine Optikscheibe angeordnet sein, welche beispielsweise eine bestimmte Struktur und/oder Maskierung aufweisen kann, beispielsweise um bei einer klaren, für einen Betrachter eine Tiefenwirkung bewirkenden Lichtscheibe das Leuchtmittel zu kaschieren. Das Gehäuse bzw. der Leuchteninnenraum kann dabei in mehrere Kammern mit jeweils eigenen Leuchtmitteln, eventuell Reflektoren und/oder Optikscheiben, sowie gegebenenfalls Lichtscheiben unterteilt sein, von denen mehrere Kammern gleiche oder jede Kammer eine andere der oben beschriebenen Funktionen erfüllen kann.

Als Lichtquelle von Leuchtmitteln für Kraftfahrzeugleuchten kommen unter anderem wegen ihres geringen Stromverbrauchs vermehrt Leuchtdioden zum Einsatz. Diese bestehen aus mindestens einem Lichtemittierende-Diode-Halbleiter-Chip, kurz LED-Chip, sowie wenigstens einer beispielsweise durch Spritzgießen angeformten, den mindestens einen LED-Chip ganz oder teilweise umhüllenden Primäroptik. Auch sind Kraftfahrzeugleuchten bekannt, in denen reine LED-Chips ohne angeformte Primäroptiken zum Einsatz kommen. Im Folgenden wird deshalb der Einfachheit halber nicht mehr zwischen Leuchtdiode und LED-Chip unterschieden und statt dessen einheitlich der Begriff LED stellvertretend für beide Ausgestaltungen verwendet, es sei denn, es ist explizit etwas anderes erwähnt. Herausragende Eigenschaften von LEDs im Vergleich zu anderen, konventionellen Lichtquellen von Leuchtmitteln sind eine wesentlich längere Lebensdauer und eine wesentlich höhere Lichtausbeute bei gleicher Leistungsaufnahme. Dadurch und unter anderem auch wegen ihrer kompakteren Abmessungen können durch Verwendung von LEDs als Lichtquelle von Leuchtmitteln besonders kompakte Kraftfahrzeugleuchten verwirklicht werden, die an fast jede nur erdenkliche Einbausituation angepasst sein können.

Die LEDs sind zur Verwendung als Lichtquellen von Leuchtmitteln für Kraftfahrzeugleuchten einzeln oder gruppenweise auf mindestens einem mit Leiterbahnen zur elektrischen Kontaktierung versehenen Leuchtmittelträger angeordnet, welcher im Leuchteninnenraum so platziert ist, dass das von den LEDs ausgestrahlte Licht möglichst verlustarm durch die wenigstens eine den Leuchteninnenraum abschließende Lichtscheibe hindurch aus der Kraftfahrzeugleuchte austritt. Bei dem Leuchtmittelträger handelt es sich im einfachsten Fall um eine oder mehrere im Leuchteninnenraum angeordnete, ebene (2-D) Platinen oder so genannte Printed Circuit Boards (PCB), im aufwändigsten Fall um einen in Form eines oder mehrerer spritzgegossener Schaltungsträger (MID; Molded-Interconnect-Device) ausgeführten, komplex geformten (3-D) und mit integrierten Leiterbahnen ausgeführten Leuchtmittelträger mit integrierter mechanischer und elektronischer Funktion. Letzterer kann gegebenenfalls, beispielsweise vermittels einer zumindest teilweisen Beschichtung gleichzeitig die Funktion zumindest eines Reflektors erfüllen.

Zum Betrieb vom LEDs als Lichtquellen für Leuchtmittel von Kraftfahrzeugleuchten können eine oder mehrere mehr oder minder komplexe elektronische Steuerschaltungen vorgesehen sein die beispielsweise auf einem oder mehreren im Leuchteninnenraum untergebrachten Leuchtmittelträgern angeordnet sein können.

Ein einfaches Beispiel für eine elektronische Steuerschaltung betrifft die Angleichung unterschiedlicher Helligkeiten einzelner LEDs oder von LED-Strängen innerhalb einer Gruppe gemeinsam betriebener, auf einem oder mehreren Leuchtmittelträgern angeordneter LEDs. Eine solche elektronische Steuerschaltung besteht aus mindestens einem oder mehreren Vorwiderständen zur Anpassung der Vorwärtsspannung der LEDs an das Bordnetz. Beispielsweise ist bekannt, die LEDs im so genannten Binning nach Vorwärtsspannung und Intensität zu sortieren. Um Unterschiede zwischen mehreren LED-Strängen auszugleichen, die jeweils aus in Reihe geschalteten LEDs gleicher Vorwärtsspannung und Intensität bestehen, und um eine homogene Helligkeitsverteilung der benachbarten LED-Stränge aus LEDs mit unterschiedlicher Vorwärtsspannung und Intensität zu erhalten, wird zumindest jeder LED-Strang mit einem anderen Vorwiderstand versehen.

LEDs bedürfen darüber hinaus beim Einsatz als Lichtquelle insbesondere in Kraftfahrzeugleuchten einer separaten Ausfallerkennung. Dies ist bedingt durch die geringe Leistungsaufnahme von LEDs im Allgemeinen. Beispielsweise ist ein in einem Kraftfahrzeug untergebrachtes Steuergerät nicht in der Lage, eine dem Ausfall einer oder weniger LEDs entsprechende Änderung der Leistungsentnahme aus dem Bordnetz zu erkennen, da eine hieraus resultierende Bordnetzspannungsänderung unterhalb der im normalen Betrieb eines Kraftfahrzeugs auftretenden Bordnetzspannungssschwankung liegt. Eine beispielsweise in der Kraftfahrzeugleuchte untergebrachte elektronische Schaltungsanordnung zur Ausfallerkennung erfasst den Ausfall einer oder mehrerer Leuchtdioden in der Kraftfahrzeugleuchte z.B. mittels eines oder mehrerer Komparatoren und teilt dies dem Steuergerät mit. Diese elektronische Schaltungsanordnung zur Ausfallerkennung kann durch eine beispielsweise auf dem Leuchtmittelträger aufgebrachte elektronische Steuerschaltung verwirklicht sein.

Darüber hinaus können LEDs weiterer elektronischer Steuerschaltungen bedürfen. Beispiele hierfür sind elektronische Steuerschaltungen:
- zur Regelung und/oder Steuerung der Helligkeit bzw. Leuchtkraft der LEDs, beispielsweise durch eine pulsweitenmodulierte Taktung der Stromversorgung für einen außerhalb des für das menschliche Auge wahrnehmbaren Bereichs gepulsten Betrieb,
- zur Kompensation oder Vermeidung elektromagnetischer Störungen, beispielsweise aufgebaut aus Kondensatoren und/oder Ferriten,
- zum Schutz der LEDs z.B. vor einer Überspannung des Bordnetzes oder vor fehlerhafter Polung, beispielsweise umfassend eine oder mehrere Zenerdioden,

Zusammengefasst muss für fast alle LED-Anwendungen eine mehr oder minder umfangreiche, für die speziellen LEDs ausgelegte elektronische Steuerschaltung z.B. auf den mindestens einen Leuchtmittelträger aufgebracht werden. Die elektronische Steuerschaltung umfasst im einfachsten Fall einen Vorwiderstand und eine Schutzdiode, kann aber je nach Anwendung auch wesentlich mehr Elektronikbauteile enthalten, wie z.B. Mikrokontroller bzw. Kontroller, Komparatoren, Transistoren, Schutzdioden, elektrische Widerstände z.B. als Vorwiderstand, Kondensatoren, Ferrite, etc.

Somit umfasst eine Kraftfahrzeugleuchte mit einer oder mehreren LEDs als Lichtquelle zumindest ein oben genanntes Elektronikbauteil sowie mindestens eine LED. Der Einfachheit halber werden LEDs und Elektronikbauteile im Folgenden unter dem Begriff Elektronikbauelemente zusammengefasst. Demnach verfügt eine Kraftfahrzeugleuchte mit einer oder mehreren LEDs als Lichtquellen neben der LED zumindest noch über ein weiteres Elektronikbauelement.

Die Elektronikbauelemente unterscheiden sich hierbei in Leistungsbauelemente, wie z.B. elektrische Widerstände, Transistoren, etc., welche im Betrieb eine starke Wärmeentwicklung aufweisen, und in wärmeempfindliche Bauelemente, wie z.B. LEDs, Kontroller, etc., welche eine mit zunehmender Betriebs- und Umgebungstemperatur deutlich abnehmende Leistung in Bezug auf Lebensdauer und Wirkungsgrad aufweisen.

Bislang werden die Elektronikbauelemente nach optimalem Leiterbahnenlayout auf einem oder mehreren Leuchtmittelträgern platziert. Nachteilig hieran ist der hohe Wärmeeintrag von Leistungsbauelementen zu wärmeempfindlichen Bauelementen.

Um die wärmeempfindlichen Bauelemente vom Wärmeeintrag der Leistungsbauelemente zu schützen ist bekannt, separate Leuchtmittelträger bzw. Bauelementeträger für die wärmeempfindlichen Bauelemente und für die Leistungsbauelemente vorzusehen. Nachteilig hieran ist der hohe Bauraumbedarf durch die Vielzahl der erforderlichen Leuchtmittelträger und Bauelementeträger sowie die damit einhergehenden hohen Kosten z.B. durch die zwischen mehreren Leuchtmittelträgern bzw. Bauelementeträgern erforderlichen elektrischen Kabelverbindungen.

Weitere Nachteile ergeben sich unter Anderem durch:
- den Bedarf zusätzlicher Bauteile, wie etwa Kabel, Stecker und Buchsen, um die voneinander getrennten Leuchtmittelträger und Bauelementeträger miteinander elektrisch zu verbinden,
- den zusätzlichen, zeit- und kostenintensiven Montageaufwand z.B. um Kabel, Stecker und Buchsen zu montieren, sowie
- die Gefahr einer Fehlmontage.

Um die wärmeempfindlichen Bauelemente vom Wärmeeintrag der Leistungsbauelemente zu schützen ist darüber hinaus bekannt, die wärmeempfindlichen Bauelemente und die Leistungsbauelemente unter Verwendung ausgedehnter Leuchtmittelträger maximal räumlich voneinander zu beabstanden. Nachteilig hieran ist der ebenfalls hohe Bauraumbedarf durch unnötig ausgedehnte, große Leuchtmittelträger sowie die damit einhergehenden hohen Kosten.

Der Erfindung liegt die Aufgabe zugrunde, eine Kraftfahrzeugleuchte mit hohem Schutz der im Leuchteninnenraum beherbergten wärmeempfindlichen Bauelemente vor der Wärmeentwicklung von ebenfalls im Leuchteninnenraum beherbergten Leistungsbauelemente zu entwickeln, welche zeitsparend und kostengünstig hergestellt werden kann.

Die Aufgabe wird gelöst durch eine Kraftfahrzeugleuchte mit den Merkmalen des Anspruchs 1.

Demnach ist eine Kraftfahrzeugleuchte mit einem durch ein Leuchtengehäuse und eine dieses abschließende Lichtscheibe umschlossenen Leuchteninnenraum vorgesehen. Der Leuchteninnenraum beherbergt zumindest einen Leuchtmittelträger mit Leiterbahnen sowie wenigstens eine auf dem Leuchtmittelträger angeordnete und mit zumindest einigen, beispielsweise zwei, der Leiterbahnen elektrisch kontaktierten LED als Lichtquelle für mindestens eine Lichtfunktion der Kraftfahrzeugleuchte. Darüber hinaus ist zusätzlich zu der wenigstens einen LED mindestens ein weiteres Elektronikbauelement auf dem Leiterbahnträger angeordnet und mit zumindest einigen, beispielsweise zwei, der Leiterbahnen elektrisch kontaktiert.

Grundsätzlich ist hierbei denkbar, dass der Leuchtmittelträger ein Teil des Leuchtengehäuses ist, dieses umfasst oder von diesem umfasst wird. Vorzugsweise handelt es sich jedoch bei dem Leuchtmittelträger um ein vom Leuchtengehäuse gesondertes Bauteil.

Das mindestens eine weitere Elektronikbauelement kann Teil einer elektronischen Schaltung sein, eine elektronische Schaltung umfassen oder von einer elektronischen Schaltung umfasst sein. Auf dem Leuchtmittelträger können eine oder mehrere LEDs als Lichtquellen angeordnet sein.

Die Elektronikbauelemente sind nach wärmeempfindlichen Bauelementen, zu denen zumindest die wenigstens eine LED zählt, und nach Leistungsbauelementen unterschieden. Die wärmeempfindlichen Bauelemente und die Leistungsbauelemente sind bevorzugt räumlich voneinander getrennt auf dem Leiterbahnträger angeordnet.

Der Leuchtmittelträger weist beispielsweise mindestens zwei Partien auf. Wenigstens eine erste Partie ist für Leistungsbauelemente vorgesehen. Zumindest eine zweite Partie ist für wärmeempfindliche Bauelemente vorgesehen. Die ersten und zweiten Partien sind durch eine oder mehrere in dem Leuchtmittelträger angeordnete, auch als Wärmegrenze, Wärmesperre oder als Wärmegap bezeichenbare Wärmebreschen voneinander abgegrenzt. Die mindestens eine Wärmebresche verhindert oder unterbindet die Wärmeleitung von der mindestens einen ersten Partie zur mindestens einen zweiten Partie, oder grenzt die Wärmeleitung zumindest auf ein für die wärmeempfindlichen Bauelemente unschädliches Maß ein. Die Partien sind durch Leiterbahnen elektrisch miteinander verbunden.

Die eine oder mehreren Wärmebreschen unterteilen den Leuchtmittelträger in z.B. warme oder heiße Partien mit hohem Wärmeeintrag durch dort verbaute Leistungsbauelemente und kühle oder kalte Partien mit dort verbauten wärmeempfindlichen bzw. thermisch sensiblen Bauelementen.

Die mindestens eine Wärmebresche erstreckt sich zumindest abschnittsweise bevorzugt beispielsweise von mindestens einer ersten Oberfläche des Leuchtmittelträgers zu mindestens einer beispielsweise gegenüberliegenden zweiten Oberfläche durch den Leuchtmittelträger hindurch.

Im einfachsten Fall kann die Wärmebresche durch einen oder mehrere Schlitze bzw. Schlitzungen verwirklicht sein. Hierdurch wird der wärmeleitende Querschnitt des Leuchtmittelträgers zwischen den Partien verringert, wodurch der Wärmeeintrag von der ersten Partie in die zweite Partie begrenzt wird. Der mindestens eine Schlitz bzw. die mindestens eine Schlitzung erstreckt sich vorzugsweise durch den Leuchtmittelträger hindurch. Beispielsweise kann ein Schlitz oder eine Schlitzung eine beispielsweise von einem Rand und/oder von einer Oberfläche des Leuchtmittelträgers her verlaufende, z.B. eingeschnittene Nut sein. Alternativ ist denkbar, dass ein Schlitz oder eine Schlitzung ein Loch im Leuchtmittelträger bildet. Beispiele für von einem Schlitz oder einer Schlitzung gebildete Löcher sind in ihrem Querschnitt kreisrunde oder ovale oder längliche oder eckige oder einen beliebigen Querschnitt aufweisende, symmetrische oder asymmetrische Durchgangslöcher oder Sacklöcher, deren Mittelpunkte aufeinander folgender Querschnitte entlang einer senkrecht oder schräg zur Oberfläche des Leuchtmittelträgers verlaufenden Gerade oder entlang einer beliebigen Kurve liegen.

Die Wärmebresche bildet in ihrer Verwirklichung als Schlitz oder Schlitzung einen die Wärmeleitung unterbrechenden Ausschnitt bzw. eine Aussparung bzw. eine für die Wärmeleitung unüberwindliche Kluft oder Leerstelle, in Form eines Abstands zwischen der mindestens einen ersten Partie und der mindestens einen zweiten Partie.

Ebenfalls ist denkbar, zusätzlich zu oder anstelle eines Schlitzes oder einer Schlitzung ein die Wärmeleitung unterbindendes oder zumindest einschränkendes Material als Wärmebresche in den Leuchtmittelträger eingebracht ist. Dieses Material ist besonders bevorzugt elektrisch isolierend.

Es ist ersichtlich, dass die Erfindung zumindest durch wenigstens eine in einem Leuchtmittelträger angeordnete Wärmebresche verwirklicht ist, die zumindest zwischen einem Leistungsbauelement, wie z.B. einem Widerstand oder einem Transistor, und einem wärmeempfindlichen bzw. thermisch sensiblen Bauelement, wie z.B. einer LED oder einem Mikrokontroller, angeordnet ist.

Vorteile der Erfindung gegenüber dem Stand der Technik ergeben sich unter anderem dadurch, dass durch die Wärmebresche trotz räumlich getrennter Anordnung zum Schutz der wärmeempfindlichen Bauelemente vor einem Wärmeeintrag durch die Leistungsbauelemente kompaktere Ausdehnungen von Leuchtmittelträgern verwirklicht werden können. Hierdurch können im Vergleich zum Stand der Technik im Umgang z.B. während der Montage einfachere, kleinere Leuchtmittelträger verwirklicht werden. Durch die im Vergleich zum Stand der Technik ohne Einschränkung des Schutzes der wärmeempfindlichen Bauelemente vor dem Wärmeeintrag durch die Leistungsbauelemente verwirklichbaren kleineren Ausdehnungen der Leuchtmittelträger werden darüber hinaus erhebliche Material- und Kosteneinsparungen bei der Herstellung von Kraftfahrzeugleuchten erreicht.

Zusätzlich ergibt sich durch die Wärmebresche ein im Vergleich zum Stand der Technik verbesserter Schutz der wärmeempfindlichen Bauelemente vor einem Wärmeeintrag durch die Leistungsbauelemente, verbunden mit einer im Vergleich zum Stand der Technik längere Lebensdauer der wärmeempfindlichen bzw. thermisch sensiblen Bauteile.

Indem die mindestens eine erste Partie und die mindestens eine zweite Partie durch Leiterbahnen elektrisch miteinander verbunden sind, wird darüber hinaus:
- der Bedarf zusätzlicher Bauteile, wie etwa Kabel, Stecker und Buchsen, vermieden, die nach dem Stand der Technik erforderlich sind, um voneinander getrennte Leuchtmittelträger und Bauelementeträger miteinander elektrisch zu verbinden.
- der zusätzliche, zeit- und kostenintensive Montageaufwand z.B. um Kabel, Stecker und Buchsen zu montieren, abgeschafft.
- die Gefahr einer Fehlmontage unterbunden.

Darüber hinaus werden durch die Erfindung weniger Leuchtmittelträger und Bauelementeträger benötigt, bzw. es kann auf separate Bauelementeträger ganz verzichtet werden. Dadurch kommt es sowohl in der Herstellung als auch in der Montage zu erheblichen Zeit- und Kosteneinsparungen.

Die Kraftfahrzeugleuchte kann beispielsweise als Kraftfahrzeugheckleuchte oder als Tagfahrleuchte ausgebildet sein.

Die Erfindung wird nachfolgend anhand von in der Zeichnung dargestellten Ausführungsbeispielen näher erläutert. Darin bezeichnen gleiche Bezugszeichen gleiche oder gleich wirkende Elemente.

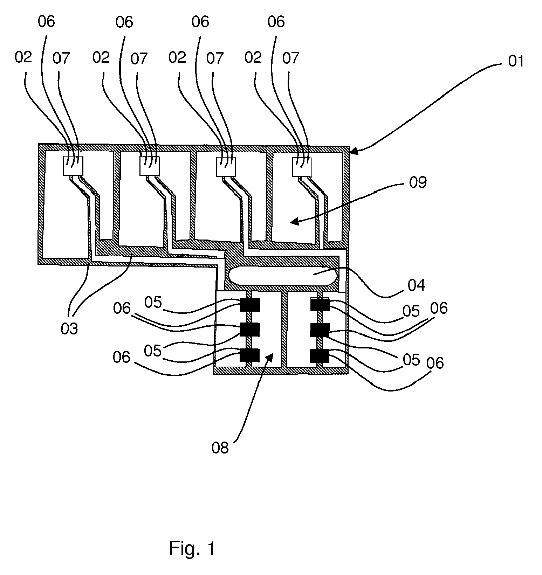

Die einzige Fig. 1 zeigt in schematischer Darstellung eine Draufsicht auf einen Leuchtmittelträger einer Kraftfahrzeugleuchte.

Eine Kraftfahrzeugleuchte umfasst wenigstens einen in Fig. 1 dargestellten, beispielsweise als in MID-Technik hergestellter, spritzgegossener Schaltungsträger mit integrierter mechanischer und elektronischer Funktion oder als ebene Platine oder PCB ausgeführten Leuchtmittelträger 01, der in einem durch ein Leuchtengehäuse und eine dieses abschließende Lichtscheibe umschlossenen Leuchteninnenraum beherbergt ist.

Der Leuchtmittelträger 01 weist Leiterbahnen 03 aus einem elektrisch leitfähigen Werkstoff auf. Auf dem Leuchtmittelträger 01 sind Elektronikbauelemente 06 angeordnet und jeweils mit zumindest einigen, beispielsweise jeweils zwei, der Leiterbahnen 03 elektrisch kontaktiert. Bei einigen der Elektronikbauelemente 06 handelt es sich um wärmeempfindliche Bauelemente 02, beispielsweise um LEDs 07, Kontroller und/oder dergleichen, welche eine mit zunehmender Betriebs- und Umgebungstemperatur deutlich abnehmende Leistung in Bezug auf Lebensdauer und Wirkungsgrad aufweisen. Beim verbleibenden Teil der Elektronikbauelemente 06 handelt es sich um Leistungsbauelemente 05, beispielsweise elektrische Widerstände, Transistoren und dergleichen, welche im Betrieb eine starke Wärmeentwicklung aufweisen.

Die LEDs 07 dienen als mindestens eine Lichtquelle für wenigstens eine Lichtfunktion der Kraftfahrzeugleuchte. Die Leistungsbauelemente 05 können Teil einer elektronischen Schaltung sein.

Um die auf dem selben Leuchtmittelträger 01 angeordneten wärmeempfindlichen Bauelemente 02 vor einem Wärmeeintrag durch die Leistungsbauelemente 05 zu schützen ist zumindest zwischen einem Leistungsbauelement 05 und einem wärmeempfindlichen Bauelement 02 wenigstens eine Wärmebresche 04 in dem Leuchtmittelträger 01 angeordnet.

Die wenigstens eine Wärmebresche 04 unterteilt den Leuchtmittelträger 01 in zumindest eine wenigstens während des Betriebs zumindest einer Lichtfunktion der Kraftfahrzeugleuchte warme oder heiße Partie 08 und zumindest eine kühle oder kalte Partie 09.

Die zumindest eine erste, wenigstens während des Betriebs zumindest einer Lichtfunktion der Kraftfahrzeugleuchte warme oder heiße Partie 08 ist dabei für Leistungsbauelemente 05 vorgesehen. Die zumindest eine zweite, wenigstens während des Betriebs zumindest einer Lichtfunktion der Kraftfahrzeugleuchte kühle oder kalte Partie 09 ist dabei für wärmeempfindliche Bauelemente 02 vorgesehen. Die mindestens eine Wärmebresche 04 ist zumindest zwischen der mindestens einen ersten Partie 08 und der mindestens einen zweiten Partie 09 vorgesehen. Die Wärmebresche 04 grenzt die erste Partie 08 von der zweiten Partie 09 ab.

In der ersten, warmen oder heißen Partie 08 kommt es durch die dort verbauten Leistungsbauelemente 05 zu einem vergleichsweise hohen Wärmeeintrag während des Betriebs zumindest einer Lichtfunktion der Kraftfahrzeugleuchte. In der zweiten Partie 09, in der bevorzugt überhaupt keine Leistungsbauelemente 05 verbaut sind, sondern vorzugsweise ausschließlich wärmeempfindliche Bauelemente 02, kommt es zu einem erheblich geringeren Wärmeeintrag durch die wärmeempfindlichen Bauelemente 02, wodurch die zweite Partie 09 im Vergleich zur ersten Partie 08 während des Betriebs zumindest einer Lichtfunktion der Kraftfahrzeugleuchte kühl oder kalt bleibt. Um die Temperatur der zweiten Partie 09 durch den vergleichsweise geringen Wärmeeintrag durch die wärmeempfindlichen Bauelemente 02 möglichst niedrig zu halten, kann die zweite Partie 09 in ihren Abmessungen größer ausgeführt sein, als die erste Partie 08. Dadurch kann eine höhere Wärmeabgabe durch Wärmeübergang an die die zweite Partie 09 umgebende Luft sichergestellt werden.

Die mindestens eine Wärmebresche 04 erstreckt sich zumindest abschnittsweise durch den Leuchtmittelträger 01 hindurch.

Die Erfindung ist insbesondere im Bereich der Herstellung von Kraftfahrzeugleuchten gewerblich anwendbar.

### Bezugszeichenliste

- 01: Leuchtmittelträger
- 02: wärmeempfindliches Bauelement
- 03: Leiterbahn
- 04: Wärmebresche
- 05: Leistungsbauelement
- 06: Elektronikbauelement
- 07: LED
- 08: erste Partie
- 09: zweite Partie

## Patentansprüche

1. Kraftfahrzeugleuchte mit einem durch ein Leuchtengehäuse und eine dieses abschließende Lichtscheibe umschlossenen Leuchteninnenraum, welcher zumindest einen Leuchtmittelträger (01) mit Leiterbahnen (03) beherbergt, auf welchem zumindest einen Leuchtmittelträger (01) zusätzlich zu mindestens einer LED (07) mindestens ein weiteres Elektronikbauelement (05) angeordnet und elektrisch kontaktiert ist, wobei die Elektronikbauelemente (06, 02, 05, 07) nach wärmeempfindlichen Bauelementen (02), zu denen wenigstens die mindestens eine LED (07) zählt, und nach Leistungsbauelementen (05) unterschieden sind, **gekennzeichnet durch**
wenigstens eine in einem Leuchtmittelträger (01) angeordnete Wärmebresche (04), die zumindest zwischen einem Leistungsbauelement (05) und einem wärmeempfindlichen Bauelement (02) angeordnet ist.

2. Kraftfahrzeugleuchte nach Anspruch 1,
**dadurch gekennzeichnet,**
**dass** die wenigstens eine Wärmebresche (04) den Leuchtmittelträger (01) in zumindest eine warme oder heiße Partie (08) mit hohem Wärmeeintrag durch mindestens ein dort verbautes Leistungsbauelement (05) und zumindest eine kühle oder kalte Partie (09) mit mindestens einem dort verbauten wärmeempfindlichen Bauelement (02, 07) unterteilt.

3. Kraftfahrzeugleuchte nach Anspruch 1 oder 2,
**dadurch gekennzeichnet,**
**dass** der Leuchtmittelträger (01) mindestens zwei Partien (08, 09) aufweist, wenigstens eine für Leistungsbauelemente (05) vorgesehene erste Partie (08) und zumindest eine für wärmeempfindliche Bauelemente (02, 07) vorgesehene zweite Partie (09), wobei die ersten und zweiten Partien (08, 09) durch wenigstens eine Wärmebresche (04) voneinander abgegrenzt sind.

4. Kraftfahrzeugleuchte nach Anspruch 1, 2 oder 3
**dadurch gekennzeichnet,**
**dass** sich die mindestens eine Wärmebresche (04) zumindest abschnittsweise durch den Leuchtmittelträger (01) hindurch erstreckt.

5. Kraftfahrzeugleuchte nach einem der vorhergehenden Ansprüche,
**dadurch gekennzeichnet,**
**dass** die Wärmebresche (04) mindestens einen Schlitz in dem Leuchtmittelträger (01) umfasst.

6. Kraftfahrzeugleuchte nach einem der vorhergehenden Ansprüche,
**dadurch gekennzeichnet,**
**dass** die Wärmebresche (04) mindestens eine Nut umfasst.

7. Kraftfahrzeugleuchte nach einem der vorhergehenden Ansprüche,
**dadurch gekennzeichnet,**
**dass** die Wärmebresche (04) mindestens ein Durchgangsloch umfasst.

8. Kraftfahrzeugleuchte nach einem der vorhergehenden Ansprüche,
**dadurch gekennzeichnet,**
**dass** die Wärmebresche (04) mindestens ein Sackloch umfasst

9. Kraftfahrzeugleuchte nach einem der vorhergehenden Ansprüche,
**dadurch gekennzeichnet,**
**dass** die Wärmebresche (04) ein die Wärmeleitung unterbindendes oder zumindest einschränkendes Material umfasst.

10. Kraftfahrzeugleuchte nach Anspruch 9,
**dadurch gekennzeichnet,**
**dass** das die Wärmeleitung unterbindende oder zumindest einschränkende Material elektrisch isolierend ist.

11. Kraftfahrzeugleuchte nach einem der vorhergehenden Ansprüche,
**dadurch gekennzeichnet,**
**dass** der Leuchtmittelträger (01) einen Teil des Leuchtengehäuses bildet, dieses umfasst oder von diesem umfasst wird.

12. Kraftfahrzeugleuchte nach einem der vorhergehenden Ansprüche,
**dadurch gekennzeichnet,**
**dass** das mindestens eine weitere Elektronikbauelement (05) Teil einer elektronischen Schaltung ist, eine elektronische Schaltung umfasst oder von einer elektronischen Schaltung umfasst wird.

13. Kraftfahrzeugleuchte nach einem der vorhergehenden Ansprüche,
**dadurch gekennzeichnet,**
**dass** die mindestens eine LED (07) als wenigstens Lichtquelle für zumindest eine Lichtfunktion der Kraftfahrzeugleuchte vorgesehen ist.

14. Kraftfahrzeugleuchte nach einem der vorhergehenden Ansprüche,
**dadurch gekennzeichnet,**
**dass** die wärmeempfindlichen Bauelemente (02, 07) und die Leistungsbauelemente (05) räumlich voneinander getrennt auf dem Leiterbahnträger (01) angeordnet sind.

## Geänderte Patentansprüche

### Geänderte Patentansprüche gemäss Regel 137(2) EPÜ.

**1.** Kraftfahrzeugleuchte mit einem durch ein Leuchtengehäuse und eine dieses abschließende Lichtscheibe umschlossenen Leuchteninnenraum, welcher zumindest einen Leuchtmittelträger (01) mit Leiterbahnen (03) beherbergt, auf welchem zumindest einen Leuchtmittelträger (01) zusätzlich zu mindestens einer LED (07) mindestens ein weiteres Elektronikbauelement (05) angeordnet und elektrisch kontaktiert ist, wobei die Elektronikbauelemente (06, 02, 05, 07) nach wärmeempfindlichen Bauelementen (02), zu denen wenigstens die mindestens eine LED (07) zählt, und nach Leistungsbauelementen (05) unterschieden sind, und wenigstens eine in einem Leuchtmittelträger (01) angeordnete Wärmebresche (04), die zumindest zwischen einem Leistungsbauelement (05) und einem wärmeempfindlichen Bauelement (02) angeordnet ist, wobei die wenigstens eine Wärmebresche (04) den Leuchtmittelträger (01) in zumindest eine warme oder heiße erste Partie (08) mit hohem Wärmeeintrag durch mindestens ein dort verbautes Leistungsbauelement (05) und zumindest eine kühle oder kalte zweite Partie (09) mit mindestens einem dort verbauten wärmeempfindlichen Bauelement (02, 07) unterteilt, und die Wärmebresche (04) als Schlitz oder Schlitzung ausgeführt ist und eine für die Wärmeleitung unüberwindliche Kluft oder Leerstelle in Form eines Abstands zwischen der mindestens einen ersten Partie (08) und der mindestens einen zweiten Partie (09) bildet sowie die zweite Partie (09) in ihren Abmessungen größer ausgeführt ist, als die erste Partie (08), um die Temperatur der zweiten Partie (08) durch den vergleichsweise geringen Wärmeeintrag durch die wärmeempfindlichen Bauelemente (02, 07) möglichst niedrig zu halten, wobei es sich bei dem Leuchtmittelträger (01) um einen in MID-Technik hergestellten, spritzgegossenen Schaltungsträger mit integrierter mechanischer und elektronischer Funktion handelt und zusätzlich zu oder anstelle eines Schlitzes oder einer Schlitzung ein die Wärmeleitung unterbindendes oder zumindest einschränkendes Material als Wärmebresche (04) in den Leuchtmittelträger (01) eingebracht ist, welches elektrisch isolierend ist.

**2.** Kraftfahrzeugleuchte nach Anspruch 1,
**dadurch gekennzeichnet,**
**dass** der Leuchtmittelträger (01) mindestens zwei Partien (08, 09) aufweist, wenigstens eine für Leistungsbauelemente (05) vorgesehene erste Partie (08) und zumindest eine für wärmeempfindliche Bauelemente (02, 07) vorgesehene zweite Partie (09), wobei die ersten und zweiten Partien (08, 09) durch wenigstens eine Wärmebresche (04) voneinander abgegrenzt sind.

**3.** Kraftfahrzeugleuchte nach Anspruch 1 oder 2,
**dadurch gekennzeichnet,**
**dass** sich die mindestens eine Wärmebresche (04) zumindest abschnittsweise durch den Leuchtmittelträger (01) hindurch erstreckt.

**4.** Kraftfahrzeugleuchte nach einem der vorhergehenden Ansprüche,
**dadurch gekennzeichnet,**
**dass** die Wärmebresche (04) mindestens eine Nut umfasst.

**5.** Kraftfahrzeugleuchte nach einem der vorhergehenden Ansprüche,
**dadurch gekennzeichnet,**
**dass** die Wärmebresche (04) mindestens ein Durchgangsloch umfasst.

**6.** Kraftfahrzeugleuchte nach einem der vorhergehenden Ansprüche,
**dadurch gekennzeichnet,**
**dass** die Wärmebresche (04) mindestens ein Sackloch umfasst

**7.** Kraftfahrzeugleuchte nach einem der vorhergehenden Ansprüche,
**dadurch gekennzeichnet,**
**dass** der Leuchtmittelträger (01) einen Teil des Leuchtengehäuses bildet, dieses umfasst oder von diesem umfasst wird.

**8.** Kraftfahrzeugleuchte nach einem der vorhergehenden Ansprüche,
**dadurch gekennzeichnet,**
**dass** das mindestens eine weitere Elektronikbauelement (05) Teil einer elektronischen Schaltung ist, eine elektronische Schaltung umfasst oder von einer elektronischen Schaltung umfasst wird.

**9.** Kraftfahrzeugleuchte nach einem der vorhergehenden Ansprüche,
**dadurch gekennzeichnet,**
**dass** die mindestens eine LED (07) als wenigstens Lichtquelle für zumindest eine Lichtfunktion der Kraftfahrzeugleuchte vorgesehen ist.

**10.** Kraftfahrzeugleuchte nach einem der vorhergehenden Ansprüche,
**dadurch gekennzeichnet,**
**dass** die wärmeempfindlichen Bauelemente (02, 07) und die Leistungsbauelemente (05) räumlich voneinander getrennt auf dem Leiterbahnträger (01) angeordnet sind.
